(19) **Europäisches Patentamt**
**European Patent Office**
**Office européen des brevets**

(11) **EP 1 680 781 B1**

(12) **EUROPEAN PATENT SPECIFICATION**

(45) Date of publication and mention
of the grant of the patent:
**07.03.2007 Bulletin 2007/10**

(51) Int Cl.:
*G10L 21/02* (2006.01)   *H04R 3/00* (2006.01)
*H04R 25/00* (2006.01)   *H03G 5/16* (2006.01)

(21) Application number: **04744486.4**

(22) Date of filing: **05.07.2004**

(86) International application number:
**PCT/IB2004/051118**

(87) International publication number:
**WO 2005/004114 (13.01.2005 Gazette 2005/02)**

(54) **SYSTEM AND METHOD FOR AUDIO SIGNAL PROCESSING**

SYSTEM UND VERFAHREN ZUR SIGNALVERARBEITUNG

SYSTEME ET PROCEDE POUR LE TRAITEMENT DES SIGNAUX AUDIO

(84) Designated Contracting States:
**AT BE BG CH CY CZ DE DK EE ES FI FR GB GR HU IE IT LI LU MC NL PL PT RO SE SI SK TR**

(30) Priority: **07.07.2003 EP 03102031**
**19.01.2004 EP 04100148**

(43) Date of publication of application:
**19.07.2006 Bulletin 2006/29**

(73) Proprietor: **Koninklijke Philips Electronics N.V.**
**5621 BA Eindhoven (NL)**

(72) Inventor: **TOURWE, Bruno, K., R.**
**NL-5656 AA Eindhoven (NL)**

(74) Representative: **Damen, Daniel Martijn et al**
**Philips Intellectual Property & Standards**
**P.O. Box 220**
**5600 AE Eindhoven (NL)**

(56) References cited:
**US-A1- 2002 015 503   US-A1- 2002 057 808**
**US-A1- 2002 071 573   US-A1- 2002 114 474**

**Description**

This invention relates to the field of sound reproduction, and more particularly to the field of digital audio signal processing.

The invention relates to a sound reproduction system comprising a digital audio signal input, a digital audio signal processor and a digital audio signal output.

The invention also relates to an audio signal processor for processing an incoming audio signal in an audio output signal. In particular the invention relates to a digital signal processor (DSP) circuit or program.

The invention also relates to a method for processing a digital audio signal.

A sound reproduction system, such as e.g. a loudspeaker telephone system, includes an output transducer, often called a loudspeaker, and an input for an audio signal. The loudspeaker produces sound pressure waves in response to the audio input signal which is representative of a desired sound pressure wave.

Intelligibility of the sound as perceived by the listener is very important, especially in noisy environments. The simplest way to increase the intelligibility is to increase the average SPL (Sound pressure level), i.e. turning up the volume. However, simply turning up the volume does not always lead to a more intelligible sound. Also, too high an output may lead to an overloading of a loudspeaker resulting in a further decrease of the intelligibility.

A number of attempts have been made to increase the intelligibility of sound

United States Patent application US 2002/0015503 proposes e.g. to increase intelligibility by individually constraining the gain factors for different frequency bands.

The existing systems and methods are, however, either very complicated, requiring complicated computations and thereby complicated circuitry (hard-ware), or, in the case of a program (soft-ware) being used, a complex program, or supply only a limited advantage.

Notwithstanding the above-mentioned references, there continues to exist a need in the art for improved systems and methods providing improved intelligibility.

It is an object of the present invention to provide a sound reproduction system and method with improved intelligibility.

To this end, the sound reproduction system in accordance with the invention is characterized in that the system comprises a digital signal processor, the digital signal processor comprising a high pass (HP) filter with a pass frequency of between a first frequency and a second frequency, preferably of between 300 Hz and 2 kHz, a compressing amplifier (22) for compression and amplification of a signal, at least amplification (gain) being performed after HP filtering, and a clipper for clipping the HP filtered, compressed and amplified signal above a clipping level.

The system in accordance with the invention is based on the following insights:

1. The incoming signal is amplified to increase the loudness, however

2. increasing the incoming signal could lead to a signal higher than the maximum digital signal, in such circumstances the signal would often be digitally clipped, leading to a distortion of the signal.

3. Low frequencies are removed from the signal, this allows the remainder of the signal to be amplified with, on average, a higher gain factor. This is done by the HP filter, situated before amplification. The lower frequencies are, in so far as intelligibility is concerned, of relatively low importance. The lower frequencies comprise much of the amplitude of the signal, so removing the lower frequencies strongly reduces the amplitude of the signal, creating head room for amplification, i.e. a stronger amplification for the remainder of the signal. A large part of the amplitude of especially speech is comprised in the lower frequencies so attenuating lower frequencies allows for a considerable increase in head room (i.e. amplification without hitting a clipping level).

4. Simply cutting the lower frequencies and increasing the output would increase loud sounds as much as the more subdued sounds. Although this leads to an improvement in intelligibility, this does not always result in a readily perceivable increase in intelligibility, especially not when the loudness range, i.e. the compressed amplitude range is large. To further increase intelligibility the device comprises a compressing amplifier for amplification and compression of a signal. The amplitude range is then compressed (as well as amplified). The clipper clips the signal above a clipping level, the clipping level is situated within the compressed amplitude range, whereby the average loudness difference is reduced. The more subdued sounds undergo a stronger amplification than the louder sounds (leading to a compression of the signal to within a compressed amplitude range) which increases intelligibility, because the more subdued sound become better distinguishable. This is done by the compressing amplifier. Any desirable functional form relating signal amplitude in to signal amplitude out may be implemented as compression relationship, e.g. with a lookup table. The loudest sounds are clipped by setting the clipping level within the compressed amplitude range, further increasing intelligibility. This is done by the clipper. The signal is clipped at a certain amplitude (clipping level) within the compressed amplitude range of which the limits, in particular the upper limit, may be set at initialization time. The compression action may at least in part be effectuated before or after HP filtering, the amplification as such (i.e. the bulk of the gain) is performed after HP filtering since it is the removal of the lower frequency components by the HP filtering which allows for the on average higher gain of the remainder (i.e. the increase in headroom).

The concept of clipper should not be understood as limited to a hard clipping (i.e. all values above a predetermined value C are set equal to C), but also comprise soft clipping, which in a subrange up to the high limit of the compressed amplitude range, applies another predetermined signal amplitude in/ signal amplitude out relationship.

Preferably the compressing amplifier is arranged not to amplify a signal having a signal strength below a threshold value.

Below a threshold value (a certain minimum amplitude) the signal is probably due to noise. Not amplifying such signals improves intelligibility, since the noise is reduced. Furthermore the difference between silence and speech is better distinguishable, which also increases intelligibility. The threshold may be set at initialization time

Preferably the digital sound processor comprises a low pass filter for filtering the signal provided by the compressing amplifier and for providing an output signal, the pass frequency of the low pass filter lying in the range 2 kHz-Fs/2, where Fs is the sample frequency.

The compression action, but in particular the clipping action may introduce disturbing overtones, which reduce the naturalness and intelligibility of the emitted sound. Furthermore due to the use of the high pass filter, the signal already comprises a relatively high proportion of high frequency tones. The low pass filter cuts out or at least reduces the overtones produced by the compressing amplifier leading to a more natural sound and increasing the intelligibility.

The high pass filter is preferably a first order or second order filter, i.e. a filter with a relatively gradual slope. It is advantageous to remove much of the energy of the low frequency components of the incoming signal to provide head room for the amplification. However, a filter with a slope that is relatively steep (a step filter being the most extreme example of such a filter) removes so much of the lower frequency components that this may result in an unnatural sounding voice. Preferably the device comprises a means for enabling a user to change the order and/or the cut/off frequency. Using a $2^{nd}$ order high pass filter results in good speech intelligibility and/or signal loudness, whereas using a $1^{st}$ order high pass filter will preserve the more natural sound of the original signal.

Preferably the system, and/or program comprises a means for activation and/or setting of the frequency dependence of the low pass filter and/or the high pass filter in dependence on the average amplification in the leveling amplification stage. The average amplification is a measure for the average gain of the signal and thereby of the loudness level of the emitted sound signal. It is advantageous when the cut-off frequency of the high-pass filter increases with increasing average loudness level of the emitted signal, and the cut-off frequency of the low pass filter decreases with increasing loudness level.

At very high amplification levels (as could happen when the device is used in loud, noisy environments) the leveling action is relatively large, this relatively large leveling action introduces a relatively large distortion of the signal, i.e. the unwanted, unnatural overtones of the signal comprise much energy. This leads to a harsh sound. The harshness of the sound sometimes and even often, as the inventors have realized leads to the listener keeping the loudspeaker, especially in mobile telephones, at some distance from the ear. Apart from the fact that holding the loudspeaker at some distance from the ear in itself will lead to a considerable reduction in signal to noise, since the signal will be reduced and the noise will be increased, the mere fact that the sound itself is perceived as harsh in fact means a reduction in intelligibility of the message given. For vocal messages the harshness of the voice often is an integral part of the message which the person speaking wishes to address the listener, sometimes even more important than the actual words of the messages. It is thus important for the intelligibility of the message, seen in a concept broader than merely whether or not words are understood, that a clear "natural" voice transfer is achieved. At lower amplification levels the "harsh sound" effect is much less audible. Selectively activating or setting the cut-off frequency at a relatively low frequency of the low pass filter at high amplification levels reduces the "harsh sound effect", while at low amplifications levels the need for use of the high pass filter is less, and not activating the high pass filter may actually lead to a more natural sound. In short, at high amplification levels and strong leveling action a relatively large part of the amplitude at high frequencies is due to artificial artifacts due to the leveling action and removing (in toto or partially) the higher frequencies removes the artifacts thus leading to a more natural sound, at relatively low amplification levels and relatively moderate leveling action, considerably more of the signal amplitude at high frequencies is of natural origin and much less due to artificial artifacts, so not using the low pass filter (or setting the cut-off frequency at a relatively high frequency is then preferable. By selectively activating the high pass filter dependent on the amplification, an improved sound reproduction is possible. Instead of activating/deactivating the low pass filter (i.e. an on/off choice) the filter characteristic of the low pass filter may be made amplification dependent, for instance having a filter cutoff frequency of 2 kHz for high amplification (loud environmental noise) and Fs/2, or e.g. 4 kHz, for low amplification or no environmental noise, or in other words wherein the cut-off frequency decreases as the loudness level increases.

Alternatively the device may have a means for manually setting the filter characteristics of the low pass filter, e.g. a knob enabling the user to set the filter cut off frequency to 2, 3 and 4 kHz depending on the (lack of) intelligibility, or personal preference. A similar argument holds for the high pass filter, at low amplification levels the need for using the high pass filter is less than at high amplification levels, so at low amplification levels the high pass filter may be deactivated or given a low cut-off frequency level, whereas at high amplification level (high loudness) the high-pass filter may be activated or its cut-off frequency set at a relatively high value, or in other words wherein the cut-off frequency of the high pass filter increases as the loudness level increases.

In a first embodiment the system comprises the high pass filter followed by an AGC followed by a limiter/clipper preferably followed by the low pass filter. This embodiment is preferred when in circumstances where signal loudness is of prime interest. A limiter scans for peaks in the audio signal and attenuates the audio portion around the peak if the attenuation is necessary to limit the amount of clipping, while yet for very loud signals allowing for clipping.

In a second embodiment, the system comprises an automatic volume leveler preceded or preferably followed by the high pass filter, providing a leveled signal, followed by a gain, and a clipper, preferably followed by the low pass filter. This embodiment is preferred when low computational effort is preferred

(Hard) clipping is a simple operation in which any signal above a threshold signal strength is reduced to said given threshold signal strength, i.e. a maximum signal strength is set. The advantage of such an embodiment is that a simple device is used, the disadvantage is that the signal is more heavily distorted, since any details in the signal above the threshold signal are lost.

In preferred embodiments the device comprises a measuring device, such as a microphone, for measuring background noise levels. The device comprises an adaptor for adapting one or more of the parameters in dependence on the measured background noise level. Such parameters are e.g. the cut-off frequency and order of the high-pass filter, the cut-off frequency and order of the low pass filter, the gain, the clipping level. Preferably for one or more of the parameters the dependency on the measured noise level is non-linear.

Within the concept of the invention a 'clipper', 'compressor', 'amplifier', 'filter', 'converter', 'comparator' etc are to be broadly understood and to comprise e.g. any piece of hard-ware (such as a clipper, compressor, amplifier etc), any circuit or sub-circuit designed for performing a clipping, compression, amplification etc function as described as well as any piece of soft-ware (computer program or sub program or set of computer programs, or program code(s)) designed or programmed to perform a clipping, compressing, filtering etc operation in accordance with the invention as well as any combination of pieces of hardware and software acting as such, alone or in combination, without being restricted to the below given exemplary embodiments. One program may combine several functions.

The invention is also embodied in any computer program comprising program code means for performing a method in accordance with the invention when said program is run on a computer as well as in any computer program product comprising program code means stored on a computer readable medium for performing a method in accordance with the invention when said program is run on a computer, as well as any program product comprising program code means for use in a telephone system in accordance with the invention, for performing the action specific for the invention.

These and further aspects of the invention will be explained in greater detail by way of example and with reference to the accompanying drawings, in which

Fig. 1 is a schematic diagram of a system including a loudspeaker, and a DSP.
Fig. 2 shows schematically a DSP in accordance with the invention
Fig. 3 shows two examples of high pass filters which may be used in the invention.
Fig. 4 shows the waveform of a typical speech signal.
Fig. 5 illustrates the waveform after having been filtered by the high pass filter
Fig. 6 shows the spectrum of the waveform shown in figures 4 and 5.
Fig. 7 illustrates one type of embodiments of the invention.
Fig. 8 depicts the functional block diagram of an exemplary AGC as schematically shown in Fig. 7.
Fig. 9 illustrates a different type of embodiment.
Fig. 10 illustrates in more detail an exemplary AVL element as schematically indicated in Fig. 9
Fig. 11 illustrates the AVL behavior of the AVL of Fig. 10.
Fig. 12 shows an example of a compression functional relationship
Fig. 13 illustrates a preferred embodiment in which parameters are adapted in dependence on a measured noise level.
Fig. 14 illustrates first, second and third order dependence of a parameter P on noise level S.

The present invention will now be described more fully hereinafter with reference to the accompanying drawings, in which preferred embodiments of the present invention are shown. This invention may, however, be embodied in many different forms and should not be construed as limited to the embodiment set forth herein; rather, these embodiments are provided so that this disclosure will be thorough and complete, and will fully convey the scope of the invention to those skilled in the art. Like numbers refer to like elements throughout.

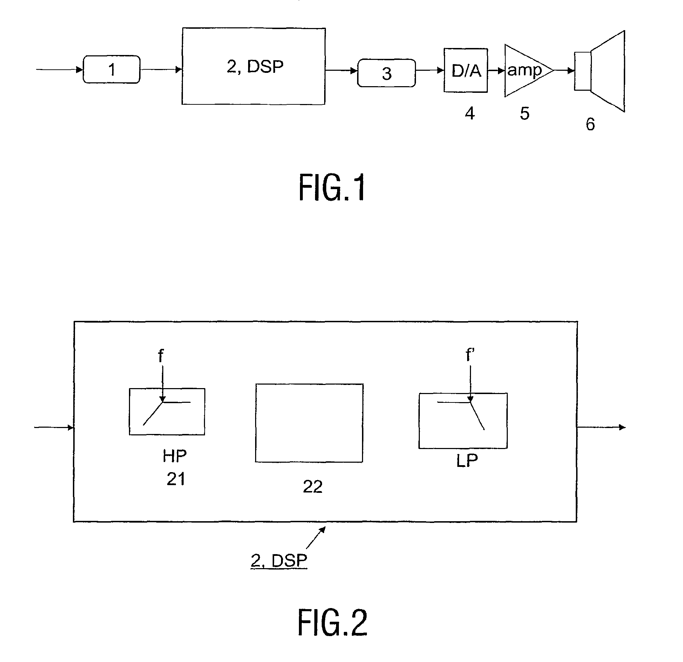

Fig. 1 illustrates schematically a sound reproduction system. Such system can for instance be a hands-free loudspeaker cellular radiotelephone for use in an automobile. When implemented as a hands-free cellular telephone, speech signals received from a far end, i.e. from a distant party, are transmitted from a cellular base station (not shown), received by the transceiver of the cellular phone (not shown), and applied to the input 1 for an incoming far end signal as an input waveform W. In this example it is assumed that the transmission back and forth between the system, in this example a telephone system, and the far end is in a digital form. If the original signals are in an analog form the system comprises an A-to-D converter to generate a digital far end signal which is then fed into input 1.

As shown in FIG. 1, the waveform is applied in a digital format at input 1 of or connected to a DSP (digital sound processor)2, which is connected or which comprises a digital output 3. The digital signal output is fed to and converted to an analog format by D-to-A converter 4 and amplified by amplifier 5 for use by the loudspeaker 6. A sound pressure wave W1 representative of the speech of the distant party is emitted by loudspeaker 5. Accordingly, the radiotelephone user hears sound pressure waveforms which are representative of the speech of the distant party.

However, the listener does not just hear the sound generated by the loud speaker, but also other sounds, which may make the sound generated by the loud speaker difficult to understand, i.e. of low intelligibility.

Turning up the volume seems a first and obvious choice to increase the intelligibility. However, the maximum output level of the loud speaker is often limited and simply turning up the volume often leads to more noise, not necessarily a better intelligibility of the signal.

To improve the intelligibility a number of co-operating measures are taken in the device and method in accordance with the invention.

Fig. 2 illustrates very schematically a DSP (digital sound processor) for use in a device in accordance with the invention. The DSP comprises a high pass filter 21 with a cut-off frequency between 300 Hz and 2 kHz, preferably between 500 and 1500, more preferably between 800 and 1200 Hz. The high pass filter removes or reduces frequency components below the cut-off frequency f.

Most of the energy of the signal has thereby been removed. This enables the remaining signal to be much more amplified (before running into problems in regards to a digital clipping, i.e. a value higher than the maximum value). The amplification is done by the compressing amplifier. Within the concept of the invention a compressing amplifier is an amplifier which amplifies the signal but also levels the average sound level, i.e. sounds having a small amplitude are more amplified than sound having a high sound level, thus reducing the signal amplitude range. This may be done in several manners e.g. a clipper/limiter arrangement, a clipper/compressor or an AVL (automated voltage leveler) followed by a gain and a clipper. A number of different techniques may be used, including using look-up tables to perform the amplification and compression. The amplitude range, in particular the upper limit of the range may be set by the manufacturer or influenced by the user e.g. by means of a loudness setter (a knob with which the user may set the loudness). Various examples will be given below. Compared to a straightforward, linear amplification of the signal (i.e. for all sound levels an equal amplification factor) the compressed amplification leads to more intelligibility of the sound. The words are more easily distinguishable, and thus the intelligibility of the sound is improved. It could also lead, however, to a distortion of the sound since the non-linear amplification of the sound introduced overtones (high frequency components at double, triple etc the original frequency) which leads to an increased harshness of the sound. This is perceived by the listener as being unpleasant, and in fact, in an important sense, reduces the intelligibility, in a broader sense, of the vocal message, since the harshness of the spoken words often forms an important aspect of the vocal message. This effect is present even without clipping, the clipping itself also introduces overtones. Intelligibility in a broader sense does not just relate to the words as such, but also to the message the speaker wishes to convey to the listener. The harshness of the sound, especially at higher average amplification, makes everybody sound angry, thus strongly reducing the finesses in emotions the speaker wishes to convey. The application of a low pass filter, as in a preferred embodiment of the device, depicted in figure 2, after the compressing amplifier reduces the perceived harshness of the voice, restoring at least to some extent the original emotional content of the spoken words, i.e. giving a much more natural sound. It is remarked that in most western languages the pitch of a word influences the emotional impact of the word, but not the meaning of the word per se. However, there are languages in which the pitch of the word plays a much larger role, leading to completely different meanings for one and the same 'word" depending on the pitch of the word. When such languages are used (which cannot be excluded) the use of the low pass filter becomes even more advantageous. The invention is in particular of advantage when used in conjunction with or in automated speech recognition systems, especially for languages in which the pitch of the spoken word influences the meaning of the words. What is above discussed in relation to spoken words, i.e. voice, equally applies when the sound reproduction system is used to reproduces music. Also in music the way music is perceived is of course dependent on whether one can hear the notes, but also the harshness of the sound is very important. The invention is thus, although of great importance to systems in which vocal messages are relayed such as telephone systems, not restricted to such systems, systems for reproducing music may equally benefit of this invention.

The leveling or compression action may be performed before HP filtering of the incoming signal or after it has been HP filtered. The amplification per se (i.e. the gain) is done after HP filtering. The clipping is done after the gain or in conjunction. When use is made of a low pass filter this is positioned after the clipper.

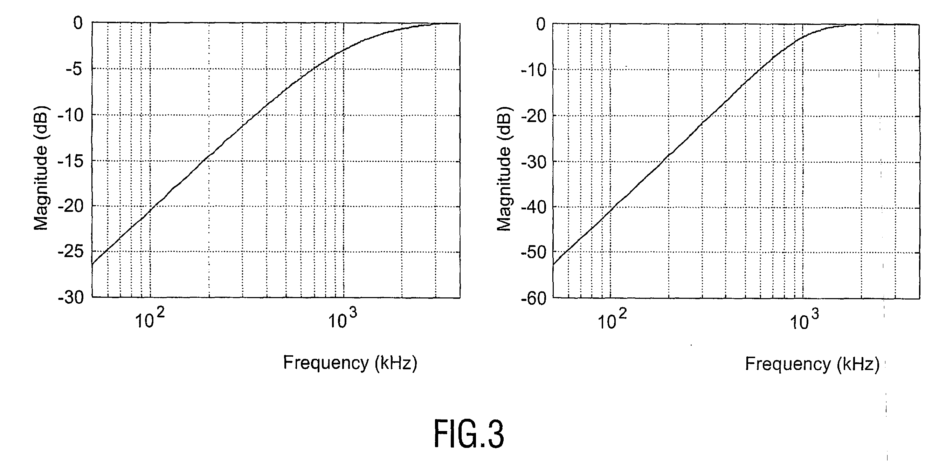

Figure 3 gives two examples of high pass filters usable in a system in accordance with the invention.

The left hand side of the figure illustrates a 1st order filter, the right hand side a second order filter. The shown high pass filter have a cut-off frequency f of approximately 1 kHz. First or second order high-pass filters (which have relatively moderate sloops of 5-15 dB per octave) are preferred. Removing too much of the low frequencies component results in a very unnatural sounding voice (or unnatural odd sounding music) Therefore the order of the high pass filter is preferably limited at 2. This also reduces the computational power required. Preferably the user can change the high pass filter from 1st to 2nd order and vice versa, or the system comprises an automatic switching mechanism dependent on the incoming signal. Using the 2nd order results in high speech intelligibility (in restricted sense, i.e. only the words) and/or signal loudness, whereas the 1st order HP filter will better preserve the natural sound of the original signal.

The HP filter may for instance consist of a biquad whose frequency magnitude response is shown in fig. 3 and whose coefficients are listed in Table I, according to the format

$$H(z) = \frac{b_0 + b_1 z^{-1} + b_2 z^{-2}}{1 + a_1 z^{-1} + a_2 z^{-2}} \; .$$

**Table 1 - Filter coefficients of the HP filters depicted in fig. 3.**

|  | 1st order | 2nd order |
|---|---|---|
| $b_0$ | 0.70710678118655 | 0.56903559372885 |
| $b_1$ | -0.70710678118655 | -1.13807118745770 |
| $b_2$ | 0.00000000000000 | 0.56903559372885 |
| $a_1$ | -0.41421356237310 | -0.94280904158206 |
| $a_2$ | 0.00000000000000 | 0.33333333333333 |

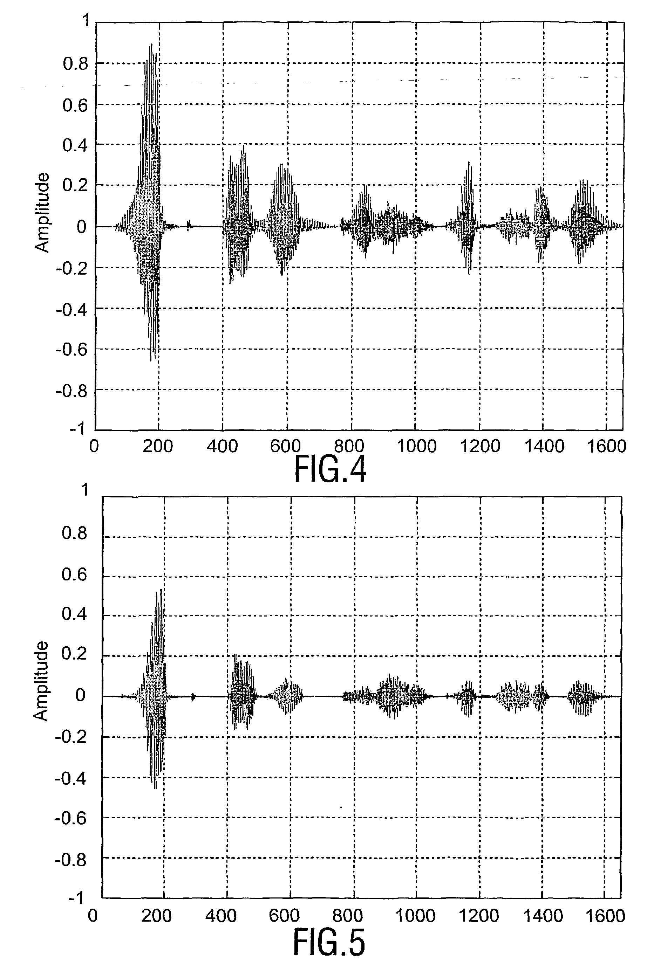

The effects of application of a high pass filter can be seen in figure 4, 5 and 6. Figure 4 shows the waveform of a typical speech signal, figure 5 the waveform after having been filtered by the high pass filter (processed by a first order IIR high pass filter, cutoff frequency at 1 kHz).

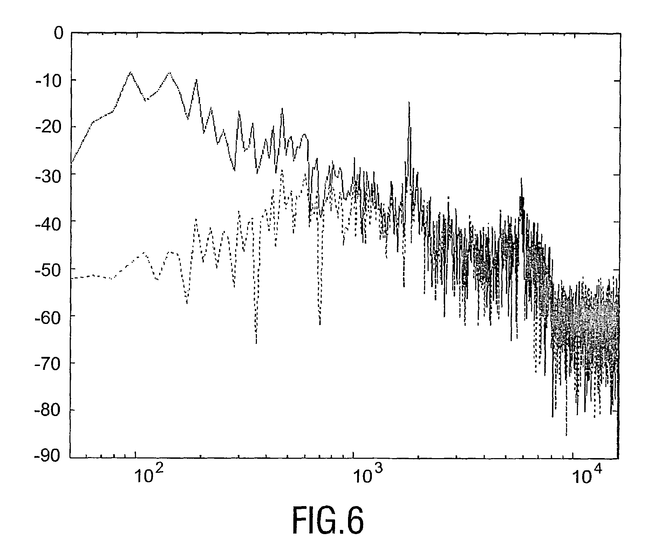

Figure 6 shows the spectrum of the waveform shown in figures 4 and 5, the signal energy of the waveform of fig. 4 being depicted in the upper curve, the signal energy of the waveform after the high-pass filter being depicted in the lower curve. As can be seen form figure 6 the signal energy of the waveform of fig. 4 is mainly concentrated in the lower frequencies (below 1 kHz).

These frequencies contribute mainly to the specific sound of the voice, but less to the speech intelligibility. This property forms one aspect of the invention.

By attenuating the lower frequencies, the signal amplitude will decrease significantly, as can be seen in figure 6, creating headroom to amplify the remaining signal which contains relatively more frequencies contributing to the speech intelligibility, as in clear from figure 6.

When compressing and amplifying the speech signal afterwards, even when clipping it, the speech intelligibility will be better than without the use of the HP filter for mainly two reasons:

-    the signal contains relatively more frequencies contributing to the speech intelligibility
-    the low frequencies are less hard clipped, resulting in less harmonics (due to clipping) disturbing the speech intelligibility

Removing too much of the low frequencies, however, would results in a very unnatural sounding voice. Therefore, the HP filter is preferably only first order e.g. a Butterworth (first order IIR) filter. This had the advantage of little computational power consumption.

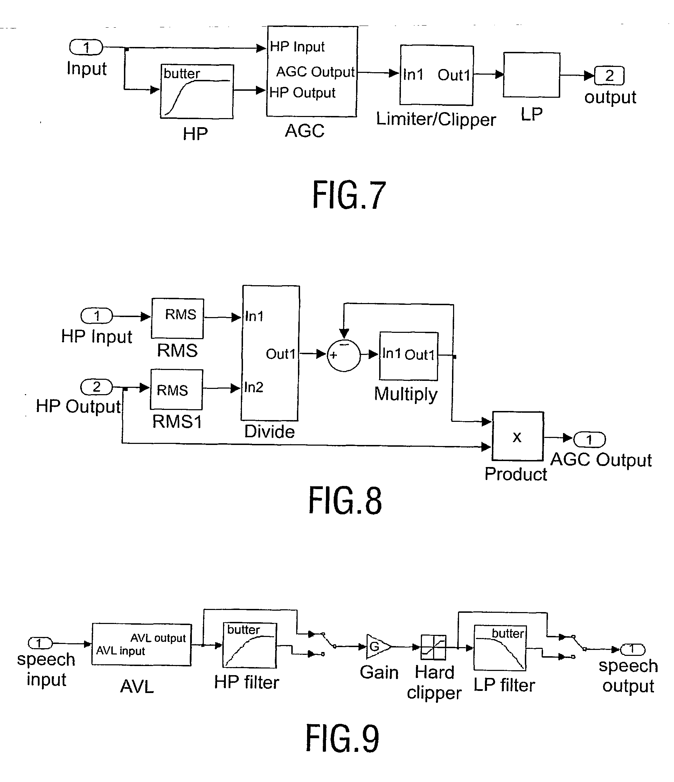

Figure 7 illustrates a detail on a system in accordance with an embodiment of the invention.

The DSP comprises a HP filter (for instance one as illustrated in figure 3, in this example for instance a Butterworth 1st or 2nd order filter with cut-off frequency value of for instance 1 kHz), followed by an AGC, followed by a limiter/clipper, followed by a low pass filter (LP).

In this example all audio streams may be mono. The sample rate frequency can be e.g. one of the following: 8 kHz, 11.025 kHz, 16 kHz, 22.05 kHz, 32 kHz, 44.1 kHz or 48 kHz.

In this example the AGC (Automatic Gain Control) acts block based, meaning that the gain factor only changes per block. In this way the computational power is kept to a minimum.

Figure 8 depicts the functional block diagram of the AGC. The gain is computed such that the RMS of the AGC output block is approximately equal to the RMS of the AGC input block. Therefore, the relation of the input RMS over the output RMS (this is the target value) is compared to the actual gain, and this gain is adjusted towards the target value. The gain variations must be smoothed to avoid too much signal distortion due to local waveform discontinuities at the block edges.

The limiter/clipper increases the loudness level while keeping signal distortion within bounds, preferably as low as possible.

In this example the limiter/clipper is a sample-based gain. In common compression techniques the gain is dependent on the available signal headroom.

The limiter/clipper may use a so-called crest-factor to calculate the allowed gain. The crest-factor is in fact the relation of the peak value and the running RMS value of the signals. In the limiter/clipper, signals with a high crest-factor, e.g. a drum beats, are clipped without severe audible distortion. Doing this, the gain can remain at a higher level, reducing the "pumping effect" of common compressors.

The gain is calculated as follows in this exemplary embodiment:

First of all, the running RMS (Root Mean Square) value of the input signal is computed. This RMS value is a smoothed average based on the recent "history" of the signal waveform. Then the peak value is calculated using a look-ahead time in order to anticipate to upcoming signal peaks.

With the RMS and the peak value, the crest-factor is computed. A so-called "depeak" factor is used to specify how hard the algorithm can clip peaky signals (high values will yield more clipping). Afterwards the gain is computed and is compared with the maximal allowed gain, which can be set by the user, and the minimal value of the two is chosen. Although not shown here the maximum allowed gain setting can be an input for the high pass filter, wherein the cut-off frequency is a function (or more in general one or more characteristics of the filter, which could apart from the value of the cut-off frequency also or alternatively e.g. include switching from a first order to a second order) of the maximum allowed gain setting.

The low pass filter LP filters the high frequencies with a more natural sound as a consequence. Although not shown here the maximum allowed gain setting can be an input for the high pass filter, wherein the cut-off frequency is a function (or more in general one or more characteristics of the filter, which could apart from the value of the cut-off frequency also or alternatively e.g. include switching from a first order to a second order) of the maximum allowed gain setting.

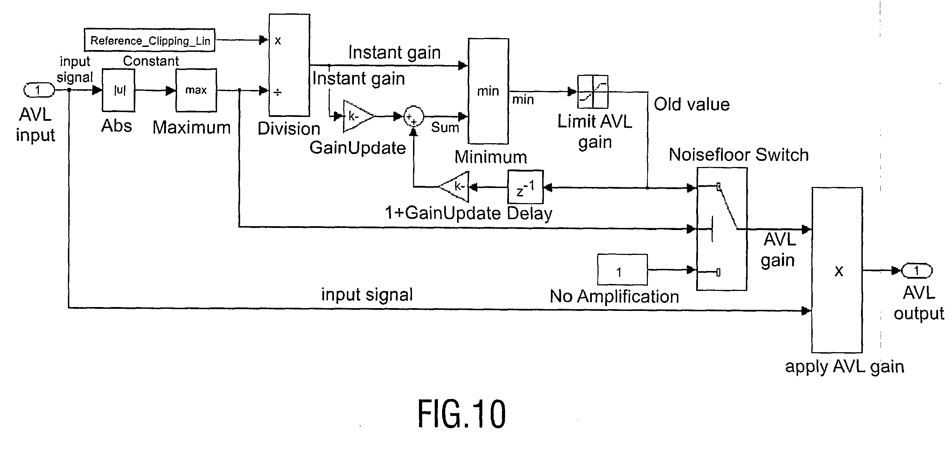

Fig. 7 and 8 illustrate one type of embodiments of the invention, fig. 9 and 10 are directed to a different type of embodiments.

Basically these embodiment comprise 4, preferably 5 elements or steps:

1. an AVL (Automatic Volume Leveler) : the AVL is a signal dependant processing block, keeping the volume of the incoming signal at an approximately constant level.
2. a first order HP (high pass) filter : this filter removes a part of the lower frequencies, creating headroom for amplification
3. a gain : increasing the SPL (Sound Pressure Level) of the signal
4. a clipper, preferably a hard clipper when a simple device is preferred: the signal is clipped at a certain amplitude, to assure linear operation of the analogue amplifier (after D/A conversion). Instead of a hard clipper, which simply clips the signal above the clipping level, a soft clipper may also be used, which clips the signal above a clipping level but also attenuates the signal at level close to the clipping level. Using a soft-clipper restores to some extent the dynamic behavior of the signal, increasing intelligibility.
5. (preferred) a first order LP (low pass) filter : the filter restores or at least improves the balance between mid-range frequencies and high frequencies is unnatural, and the signal sounds rather harsh; this filter makes the processed sound more pleasant to listen to.

In this example the input is a speech input, but it is remarked that the input may be any sound signal.

Figure 10 illustrates in more detail the AVL element.

Figure 10 shows the block diagram of the AVL. Division of the maximum output amplitude (called **"Reference_ Clipping_Lin"** in Fig. 10) by the absolute value of the maximum amplitude of the signal across the entire input block yields the gain that can be applied to the block without any clipping (called **"Instant gain"**). The parameter **"GainUpdate"** is typically 1/1000th. Thus, the signal after the sum is increased each block with an amount depending on the "Instant gain". Doing so, the AVL gain will be increased faster for higher values of "Instant gain".

Since the eventual gain applied to the input signal (**"AVL gain"**) should not be higher than (**"Instant gain"**), the minimum of both is taken (**"Min"**). The minimum block also assures that the AVL gain is decreased immediately when the incoming signal amplitude increases. To prevent that silent parts in the input signal are amplified too much, the signal after the minimum block is limited (typically 12 dB). Note that, since the maximum output amplitude is not necessarily equal to the linear level representing 0 dB, the AVL gain can be smaller than 1.

Last, if the amplitude of the input signal is smaller than a certain value, for example the signal noise floor, no gain will be applied. This is a secondary functionality, in preferred embodiments, which can also be used as a functionality in other types of compressing amplifiers to prevent small input signals from being amplified, noise is then not amplified, which increases the intelligibility of the sound.

Numeric example:

- sample rate is 8 kHz
- block length is 80 samples
- word length is 16 bit
- maximum output amplitude is 32768 (0 dB)
- input signal is sinusoidal with amplitude 32768 (0 dB), frequency >= 100 Hz (at least one sine period per block)
- current AVL gain is 1 (0 dB)
- GainUpdate = 0.001
- AVL gain **("Old value")** is limited at 12 dB

Now, the input signal amplitude decreases by 40 dB (factor 100 on a linear scale). The table below shows how the different signals inside the AVL change with time.

| Input block | Time (ms) | Input amplitude | Instant gain | Sum | Old value | AVL gain |
|---|---|---|---|---|---|---|
| | | | | | | |
| -2 | -20 | 32768,00 | 1 | | 1 | 1,00 |
| -1 | -10 | 32768,00 | 1 | 1,00 | 1,00 | 1,00 |
| 0 | 0 | 327,68 | 100 | 1,10 | 1,10 | 1,10 |
| 1 | 10 | 327,68 | 100 | 1,20 | 1,20 | 1,20 |
| 2 | 20 | 327,68 | 100 | 1,30 | 1,30 | 1,30 |
| 3 | 30 | 327,68 | 100 | 1,40 | 1,40 | 1,40 |
| 4 | 40 | 327,68 | 100 | 1,51 | 1,51 | 1,51 |
| ... | ... | ... | ... | ... | ... | ... |
| 25 | 250 | 327,68 | 100 | 3,66 | 3,66 | 3,66 |
| 26 | 260 | 327,68 | 100 | 3,76 | 3,76 | 3,76 |
| 27 | 270 | 327,68 | 100 | 3,87 | 3,87 | 3,87 |
| 28 | 280 | 327,68 | 100 | 3,97 | 3,97 | 3,97 |
| 29 | 290 | 327,68 | 100 | 4,07 | 4,00 | 4,00 |
| 30 | 300 | 327,68 | 100 | 4,10 | 4,00 | 4,00 |

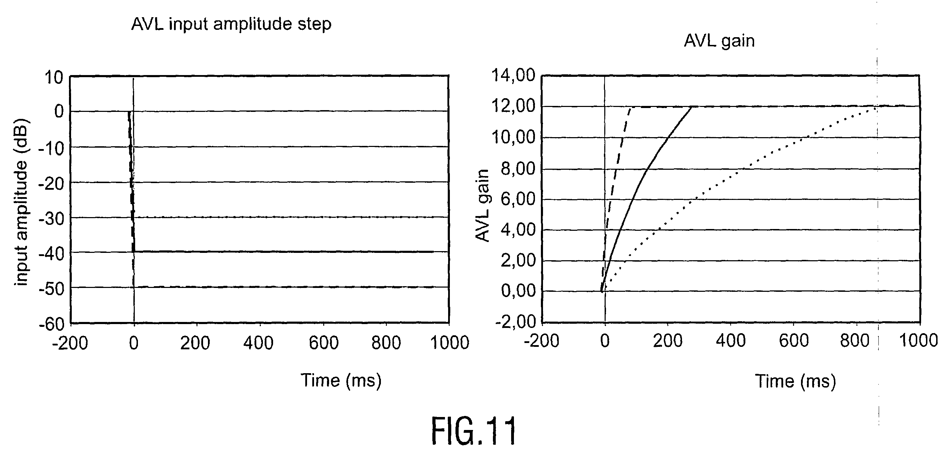

The AVL behavior is also shown in figure 11.

The left graph shows the step change of the amplitude of three input signals. The right graph shows that the AVL gain increases faster for large changes in amplitude. This is a preferred embodiment further improving intelligibility.

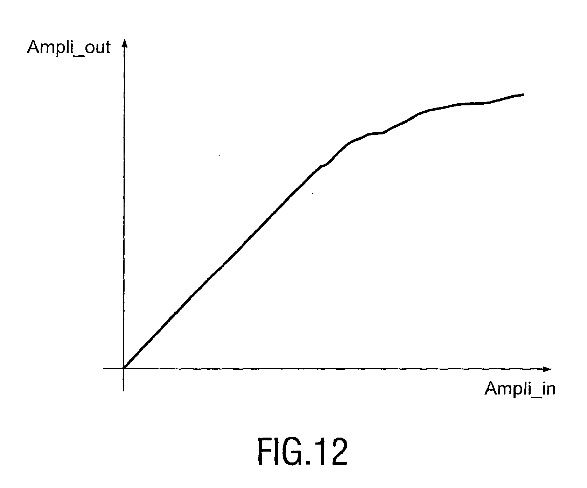

Fig. 12 shows an example of a compression function. Upto a certain value the signal is left untreated (multiplied by one) and above that value the outputted signal amplitude is smaller than the inputted signal amplitude, i.e. the signal is compressed. A functional form which only applies compression in the highest regions as in Fig. 12 may be used for the clipper, whereas a functional form which provides a compression strategy over a larger region (e.g. the whole input signal range) may be used for the compressing amplifier.

The invention may be used in various devices. The invention is in particular useful for hands free mobile phones. However, it is applicable for all sound reproduction systems, especially those which run on a device with a limited voltage supply and/or small loudspeaker. A list of possible applications:

- handsets (mobile phone, DECT, etc.);
- portable devices, e.g. a portable DVD player
- PDA'S;
- car-kits
- TV's; computers;
- web-terminals;
- answering machines;

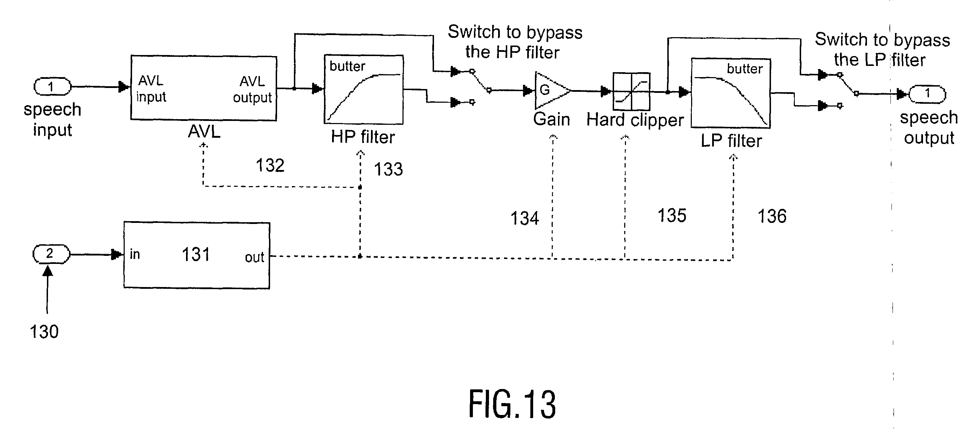

For instance in the examples given so far all or most of the data and settings for the various elements are fixed. However, within preferred embodiments of the invention the settings of the various elements are made adaptive to a measurement of environmental noise. Figure 13 illustrates such as example. Using a measuring device 130 for measuring background noise, such as e.g. a separate microphone, and an adaptor 131 the settings for one or more of the different elements (AVL (gain), HP-Filter (cut-off frequency), Gain (gain G), Hard Clipper (Clipping level), LP Filter (cut-off frequency)) are adapted.

The different adaptations are labeled 132 to 136.

The noise measurement may give a single data expressing the overall noise S or may give a noise figures for different noise band $S_{f1}$, $S_{f2}$, $S_{f3}$ etc. If noise figures are measured for different noise bands an average or total noise may be calculated for instance $S_{av}=\Sigma S_{fi}$, or weighted according to a dB(A) scale for instance $S_{av}=\Sigma w_i S_{fi}$ where $w_i$ are weighting coefficients of the dB(A) scale. The noise level is measured by an amplitude measurement.

The different adaptations will be discussed by means of examples.

132: Adaptations of the AVL settings:

In the AVL the AVL gain is limited (see figure 10, AVL gain limit), and below a certain level no amplification is applied (see figure 10, box below which is stated no amplification, determining the noise floor witch). Depending on the measured noise S the noise floor switch is increased and the limit to the AVL gain is increased.

133: Adaptations to the HP filter:

The cut-off frequency is adapted to the measured noise. The higher the noise level the larger the cut-off frequency. For adaptive embodiments the cut-off frequency may advantageously range over a broader range than for non-adaptive embodiments. Whereas for non-adaptive embodiments the cut-off frequency advantageously ranges between 300 Hz and 2 kHz for adaptive embodiments the cut-off frequency advantageously range between 50 Hz (for situations in which there is substantially no noise) to typically up to 2 kHz for high-noise-level situations.

In adaptive processing mode, the filter cut-off frequency is thus updated according to the amount of environmental noise, and ranges typically from a very low value e.g. 50 Hz (no environmental noise) and 2 kHz (loud environmental noise). More low frequencies are removed in loud noisy environments to create more headroom to amplify the signal afterwards. A maximum of 2 kHz is recommended to avoid removal of frequencies contributing to the speech intelligibility. The filter coefficients are calculated at run-time.

The relation between cut-off frequency to noise level is preferably set as follows: $f_{cut-off}=f_0+\Delta f(S)$ where $f_0$ is the low noise limit (e.g. 50, 100 or 300 Hz) and $\Delta f$ is a higher than linear (proportional to $S^i$ where i is greater than 1) function of the noise level.

In more complex embodiment not only the cut-off frequency may be dependent on the measured noise level but also the shape of the filter function, e.g. whether the filter function is a first order or a second order filter function.

134: Adaptations for the gain G.

The gain G is increased as the noise level increases. However, the gain preferably does not increase linearly with the noise level but rather as follows: $G(S)=G_0 + cS'$ where i is more than 1, e.g. 2 or 3, and c is a constant where c may be zero below a threshold value of S. A simple relationship is for instance $G(S)=G_0 + cS^2$, i.e. the gain does not depend linearly on the noise, but stays at or close to the nominal value to increase rapidly at high noise levels.

The increase in gain has a positive effect, but also a negative. By increasing the gain non-linearly as a non-linear function of noise a better balance between the positive and negative effects may be obtained.

The value of the gain is e.g. adapted to the amount of environmental noise (in adaptive processing mode) ranging from 0dB to +18 dB.

135: Adaptations for the clipper:

The clipping action is increased as the noise level increases. This is preferably a non-linear function of the noise. The maximum level above which the signal is clipped may be reduced by 12 dB for high noise levels. For instance without noise the digital clipping level may be 0 dB, whereas at high noise levels clipping is set at -12 dB.

136: Adaptations for the Low pass filter.

In the absence of noise the cut-off frequency is set at the high limit e.g. $F_s/2$. For maximum noise the cut-off frequency is set at the lower limit, e.g. 2 kHz.

In adaptive processing mode, the filter cutoff frequency is updated according to the amount of environmental noise, and ranges e.g. from 3.900 kHz (no environmental noise) to 2 kHz (loud environmental noise) for narrow-band speech applications (sample rate is 8 kHz). The filter coefficients are calculated at run-time.

Preferably the functional relationship between the measured noise level and the cut-off frequency is $f_{cut-offLP}=f_{0LP}-\Delta f_{LP}$ where $\Delta f_{LP}$ is a non-linear function of the measured noise level, e.g. proportional to the quadrature of the noise level.

In these embodiments the algorithm used is designed to operate adaptively, driven by the amount of environment (near-end) noise. This results in a user-friendly device feature that allows the device user to use its device (e.g. a GSM) in varying conditions concerning environmental noise, without the need of any further interaction to control the GSM volume level.

When used in adaptive processing mode, the parameters of the processing blocks are adapted for incoming samples according to the environmental noise. The algorithm adapts parameters according to the environmental noise. The amount of noise may be measured by a separate microphone or estimated using the device (GSM) microphone (for a single microphone application).

The main focus of the invention is and remains speech intelligibility. This is given higher priority than naturalness and warmth of the voice. When the environmental noise decreases in volume (operating in adaptive processing mode), the parameters are preferably adapted very quickly such that the naturalness and warmth of the incoming signal are restored.

In the adaptive mode the amount of environmental noise influences the different processing block parameters. The noise may range ranging from 'no environmental noise' to 'loud environmental noise'.

The term 'no environmental noise' does not mean complete silence, but regular noises such as fan noise, background music, etc. In a typical environment, the background noise is typically around 50 dB(A). The term 'loud environmental noise' refers to the noise of a passing train or subway, noise inside a dance club, etc. These noises can measure up to 100 dB(A).

The noise may be measured by measuring spectral amplitude information of the environmental noise and calculating a single value representing the amount of noise. One or more, preferably most, most preferably all of the parameters of the different elements (AVL, HP-filter, gain, clipper, LP-filter) are adapted according to this single value, by interpolation between their minimum and maximum values.

As explained above this interpolation is not necessarily linear. Tests using linear interpolation showed that for 'medium' environmental noises, the algorithm effect was too large.

Using a higher, for instance second or third order interpolation, the effect is smaller compared to linear interpolation for the same environmental noise. For loud environmental noises, the amount of effect is equal.

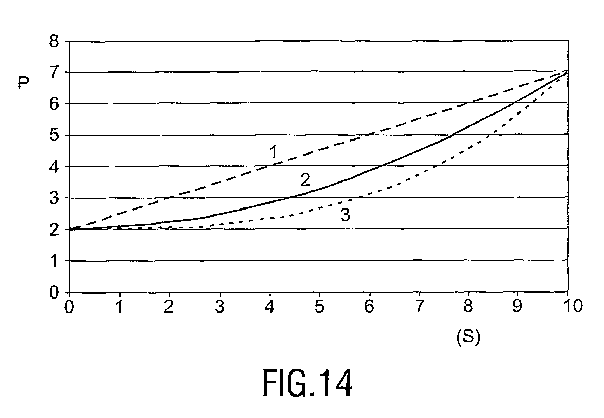

Figure 14 illustrates the adaptive behavior of a parameter (for instance the gain G, a cut-off frequency, clipping level). The parameter P varies in this example between a lower limit value $P_{low}$, in this example 2, to a high limit value $P_{high}$, in this example 7, as a function of the measured noise level, in this example the average noise amplitude S. The different curves labeled 1, 2 and 3 give first (linear), second (quadratic) and third order dependency of the parameter on the measured noise level. The higher the order the more pronounced the adaptive effect is at high noise levels.

In short the invention can be described as follows:

A sound reproduction system comprises a digital audio signal input (1), a digital audio signal processor (2, DSP) and a digital audio signal output (1) wherein the digital signal processor (2, DSP) comprises a high pass filter (21) with a pass frequency (f) of between 300 Hz and 2 kHz, a compression amplifier (22) for compression and amplification of a signal to within a signal amplitude range and a clipper for clipping the signal above a clipping level, and preferably a low pass filter (23) for filtering the signal provided by the compressing amplifier and for providing an output signal, the pass frequency of the low pass filter (f) lying in the range 2 kHz-Fs/2 where Fs is the sampling frequency. Fs/2 may be e.g. 4 kHz.

Many further variations are possible within the scope of the invention as defined in the claims.

**Claims**

1. A sound reproduction system comprising a digital audio signal input (1), a digital audio signal processor (2, DSP) and a digital audio signal output (1) wherein the digital signal processor (2, DSP) comprises a high pass (HP) filter (21) with a pass frequency (f) of between a first and a second frequency, a compressing amplifier (22) for compression and amplification of a signal, at least amplification being performed after HP filtering, and a clipper for clipping the HP filtered, compressed and amplified signal above a clipping level.

2. A sound reproduction system as claimed in claim 1, wherein the pass frequency (f) is a frequency between 300 Hz and 2 kHz.

3. A sound reproduction system as claimed in claim 1, wherein the high pass filter is a first order or second order filter.

4. A sound reproduction system as claimed in claim 1 wherein the device comprises a measuring device (130) for measuring background noise and an adaptor 131 for adapting one or more parameters (f, order) for the high pass filter (HP).

5. A sound reproduction system as claimed in claim 4, wherein the pass frequency is adaptable between 50 and 2 kHz.

6. A sound reproduction system as claimed in claim 1, wherein the compressing amplifier is arranged not to amplify a signal having a signal strength below a threshold value.

7. A sound reproduction system as claimed in claim 1, wherein the device comprises a measuring device 130 for measuring background noise and an adaptor 131 for adapting one or more parameters for the compressing amplifier (22).

8. A sound reproduction system as claimed in claim 1, wherein the digital audio processor comprises a low pass filter (23) for filtering the signal provided by the compressing amplifier and for providing an output signal, the pass frequency of the low pass filter (f') lying in the range 2 kHz-Fs/2 where Fs is the sampling frequency.

9. A sound reproduction system as claimed in claim 8, wherein the device comprises a measuring device 130 for measuring background noise and an adaptor 131 for adapting one or more parameters (f'') for the low pass filter.

10. A sound reproduction system as claimed in claim 9, wherein the system comprises a means for activation and/or setting of the frequency dependence of the low pass filter in dependence on the amplification in the compressing amplifier.

11. A sound reproduction system as claimed in any of the claims 4, 7 or 9, wherein the one or more of the said parameters is a non-linear function of the measured noise level.

12. A sound reproduction system as claimed in claim 1, wherein the system comprises the high pass filter followed by an AGC followed by a limiter/clipper.

13. A sound reproduction system as claimed in claim 1, wherein the system comprises an automatic volume leveler preceded, or preferably, followed by the high pass filter, providing a leveled signal, followed by a gain and a clipper.

14. A method for processing digital sound signals in which method frequency component of the sound signal lower than a cut-off frequency (f) between a first and a second frequency are attenuated, the sound signals are amplified and compressed to within a signal band width and clipped above a clipping level within the signal band width.

15. A method as claimed in claim 14, wherein the cut-off frequency is between 300 Hz and 2 kHz.

16. A method as claimed in claim 14 wherein a noise level is measured and the cut-off frequency (f) is determined in dependence on the measured noise level (S).

17. A method as claimed in claim 16, wherein the cut-off frequency is determined by a non-linear function of the noise level (S).

**18.** A method as claimed in claim 16, wherein the cut-off frequency ranges between 50 Hz and 2 kHz.

**19.** A method as claimed in claim 14, wherein after compression and clipping frequency components of the resulting digital signal below a cut off frequency f between 2 and 4 kHz are attenuated.

**20.** A method as claimed in claim 19 wherein a noise level is measured and the cut-off frequency (f') is determined in dependence on the measured noise level (S).

**21.** A method as claimed in claim 20, wherein the cut-off frequency (f') is determined by a non-linear function of the noise level (S).

**22.** A method as claimed in claim 14, wherein activation and/or setting of the frequency dependence of the low pass filter is performed in dependence on the amplification in the leveling amplification step.

**23.** Computer program comprising program code means for performing a method as claimed in any one of claims 14 to 22 when said program is run on a computer.

**24.** Computer program product comprising program code means stored on a computer readable medium for performing a method as claimed in any one of claims 14 to 22.


**Patentansprüche**

**1.** Tonwiedergabesystem mit einem digitalen Audiosignaleingang (1), einem digitalen Audiosignalprozessor (2, DSP) und einem digitalen Audiosignalausgang (1), wobei der digitale Signalprozessor (2, DSP) ein Hochpassfilter (HP) (21) mit einer Durchlassfrequenz (f) zwischen einer ersten und einer zweiten Frequenz aufweist, ein Kompressionsfilter (22) zur Kompression und Verstärkung eines Signals, wobei wenigstens die Verstärkung nach der HP-Filterung durchgeführt wird, und einen Amplitudenbegrenzer zum begrenzen des HP-gefilterten, komprimierten und verstärkten Signals über einem Begrenzungspegel.

**2.** Tonwiedergabesystem nach Anspruch 1, wobei die Durchlassfrequenz (f) eine Frequenz zwischen 300 Hz und 2 kHz ist.

**3.** Tonwiedergabesystem nach Anspruch 1, wobei das Hochpassfilter ein Filter erster oder zweiter Ordnung ist.

**4.** Tonwiedergabesystem nach Anspruch 1, wobei die Anordnung eine Messanordnung (130) aufweist zum Messen von Hintergrundrauschen und einen Adapter (131) zum Anpassen eines oder mehrerer Parameter (f, order) für das Hochpassfilter (HP).

**5.** Tonwiedergabesystem nach Anspruch 4, wobei die Durchlassfrequenz zwischen 50 Hz und 2 kHz anpassbar ist.

**6.** Tonwiedergabesystem nach Anspruch 1, wobei der komprimierende Verstärker dazu vorgesehen ist, ein Signal mit einer Signalstärke unterhalb eines Schwellenwertes nicht zu verstärken.

**7.** Tonwiedergabesystem nach Anspruch 1, wobei die Anordnung eine Messanordnung 130 zum messen von Hintergrundrauschen und einen Adapter 131 zum Anpassen eines oder mehrerer Parameter für den Kompressionsverstärker (22) aufweist.

**8.** Tonwiedergabesystem nach Anspruch 1, wobei der digitale Audioprozessor ein Tiefpassfilter (23) zum Filtern des von dem Kompressionsverstärker gelieferten Signals und zum Liefern eines Ausgangssignals, wobei die Durchlassfrequenz des Tiefpassfilters (f) in dem Bereich 2 kHz-Funkstation/2 liegt, wobei Funkstation die Abtastfrequenz ist.

**9.** Tonwiedergabesystem nach Anspruch 8, wobei die Anordnung eine Messanordnung 130 aufweist zum Messen von Hintergrundrauschen und einen Adapter 131 zum Anpassen eines oder mehrerer Parameter (f) für das Tiefpassfilter.

**10.** Tonwiedergabesystem nach Anspruch 9, wobei das System ein Mittel aufweist zum Aktivieren und/oder Einstellen der Frequenzabhängigkeit des Tiefpassfilters von der Verstärkung in dem Kompressionsverstärker.

**11.** Tonwiedergabesystem nach einem der Ansprüche 4, 7 oder 9, wobei der eine oder mehrere der genannten Parameter eine nicht lineare Funktion des gemessenen Rauschpegels ist.

**12.** Tonwiedergabesystem nach Anspruch 1, wobei das System das Hochpassfilter mit einer nachfolgenden AVR und einem nachfolgenden Begrenzer aufweist.

**13.** Tonwiedergabesystem nach Anspruch 1, wobei das System einen automatischen Lautstärkegleichmacher aufweist, dem das Hochpassfilter vorhergeht oder, vorzugsweise, folgt, der ein gleichgemachtes Signal liefert, wonach eine Verstärkung und eine Begrenzung folgt.

**14.** Verfahren zum Verarbeiten digitaler Tonsignale, wobei in diesem Verfahren Frequenzanteile des Tonsignals, niedriger als eine Grenzfrequenz (f) zwischen einer ersten und einer zweiten Frequenz gedämpft werden, wobei die Tonsignale verstärkt werden und komprimiert bis innerhalb einer Signalbandbreite und über einem Begrenzungspegel innerhalb der Signalbandbreite begrenzt werden.

**15.** Verfahren nach Anspruch 14, wobei die Grenzfrequenz zwischen 300 Hz und 2 kHz liegt.

**16.** Verfahren nach Anspruch 14, wobei ein Rauschpegel gemessen wird und die Grenzfrequenz (f) in Abhängigkeit von dem gemessenen Rauschpegel (S) bestimmt wird.

**17.** Verfahren nach Anspruch 16, wobei die Grenzfrequenz durch eine nichtlineare Funktion des Rauschpegels (S) bestimmt wird.

**18.** Verfahren nach Anspruch 16, wobei die Grenzfrequenz zwischen 50 Hz und 2 kHz liegt.

**19.** Verfahren nach Anspruch 14, wobei nach Kompression und Begrenzung Frequenzanteile des resultierenden digitalen Signals unterhalb einer Grenzfrequenz f zwischen 2 kHz und 4 kHz gedämpft werden.

**20.** Verfahren nach Anspruch 19, wobei ein Rauschpegel gemessen wird und die Grenzfrequenz (f) in Abhängigkeit von dem gemessenen Rauschpegel (S) bestimmt wird.

**21.** Verfahren nach Anspruch 20, wobei die Grenzfrequenz (f) durch eine nicht lineare Funktion des Rauschpegels (S) bestimmt wird.

**22.** Verfahren nach Anspruch 14, wobei Aktivierung und/oder Einstellung der Frequenzabhängigkeit des Tiefpassfilters in Abhängigkeit von der Verstärkung in dem begrenzenden Verstärkungsschritt durchgeführt wird.

**23.** Computerprogramm mit Programmcodemitteln zum Durchführen eines Verfahrens nach einem der Ansprüche 14 bis 22, wenn das genannte Programm in einem Computer läuft.

**24.** Computerprogrammprodukt mit Programmcodemitteln, die auf einem vom Computer auslesbaren Medium gespeichert sind zum Durchführen eines Verfahrens nach einem der Ansprüche 14 bis 22.

**Revendications**

**1.** Système de reproduction sonore comprenant une entrée de signal audio numérique (1), un processeur de signal audio numérique (2, DSP) et une sortie de signal audio numérique (1), dans lequel le processeur de signal numérique (2, DSP) comprend un filtre passe-haut (HP) (21) avec une fréquence de passage (f) entre une première et une deuxième fréquence, un amplificateur compresseur (22) pour comprimer et amplifier un signal, l'amplification au moins étant réalisée après filtrage HP, et un écrêteur pour écrêter le signal filtré HP, compressé et amplifié au-dessus d'un niveau d'écrêtage.

**2.** Système de reproduction sonore selon la revendication 1, dans lequel la fréquence de passage (f) est une fréquence entre 300 Hz et 2 kHz.

**3.** Système de reproduction sonore selon la revendication 1, dans lequel le filtre passe-haut est un filtre du premier ordre ou du deuxième ordre.

**4.** Système de reproduction sonore selon la revendication 1, dans lequel le dispositif comprend un dispositif de mesure (130) pour mesurer un bruit d'arrière-plan et un adaptateur 131 pour adapter un ou plusieurs paramètres (f, ordre) pour le filtre passe-haut (HP).

**5.** Système de reproduction sonore selon la revendication 4, dans lequel la fréquence de passage est adaptable entre 50 et 2 kHz.

**6.** Système de reproduction sonore selon la revendication 1, dans lequel l'amplificateur compresseur est aménagé pour ne pas amplifier un signal ayant une force de signal en dessous d'une valeur de seuil.

**7.** Système de reproduction sonore selon la revendication 1, dans lequel le dispositif comprend un dispositif de mesure 130 pour mesurer un bruit d'arrière-plan et un adaptateur 131 pour adapter un ou plusieurs paramètres pour l'amplificateur compresseur (22).

**8.** Système de reproduction sonore selon la revendication 1, dans lequel le processeur audio numérique comprend un filtre passe-bas (23) pour filtrer le signal fourni par l'amplificateur compresseur et pour fournir un signal de sortie, la fréquence de passage du filtre passe-bas (f) étant dans l'intervalle 2 kHz-$F_s$/2, où $F_s$ est la fréquence d'échantillonnage.

**9.** Système de reproduction sonore selon la revendication 8, dans lequel le dispositif comprend un dispositif de mesure 130 pour mesurer un bruit d'arrière-plan et un adaptateur 131 pour adapter un ou plusieurs paramètres (f) pour le filtre passe-bas.

**10.** Système de reproduction sonore selon la revendication 9, dans lequel le système comprend un moyen d'activation et/ou d'établissement de la dépendance de fréquence du filtre passe-bas en fonction de l'amplification dans l'amplificateur compresseur.

**11.** Système de reproduction sonore selon l'une quelconque des revendications 4, 7 ou 9, dans lequel lesdits un ou plusieurs paramètres sont une fonction non linéaire du niveau de bruit mesuré.

**12.** Système de reproduction sonore selon la revendication 1, dans lequel le système comprend le filtre passe-haut suivi par un AGC suivi par un limiteur/écrêteur.

**13.** Système de reproduction sonore selon la revendication 1, dans lequel le système comprend un niveleur de volume automatique précédé, ou de préférence suivi, par le filtre passe-haut, fournissant un signal nivelé, suivi par un gain et un écrêteur.

**14.** Procédé de traitement de signaux sonores numériques, procédé dans lequel une composante de fréquence du signal sonore inférieure à une fréquence de coupure (f) entre une première et une deuxième fréquence est atténuée, les signaux sonores sont amplifiés et compressés dans une largeur de bande de signal et écrêtés au-dessus d'un niveau d'écrêtage dans la largeur de bande de signal.

**15.** Procédé selon 1a revendication 14, dans lequel la fréquence de coupure est entre 300 Hz et 2 kHz.

**16.** Procédé selon la revendication 14, dans lequel un niveau de bruit est mesuré et la fréquence de coupure (f) est déterminée en fonction du niveau de bruit mesuré (S).

**17.** Procédé selon la revendication 16, dans lequel la fréquence de coupure est déterminée par une fonction non linéaire du niveau de bruit (S).

**18.** Procédé selon la revendication 16, dans lequel la fréquence de coupure va de 50 Hz à 2 kHz.

**19.** Procédé selon la revendication 14, dans lequel après compression et écrêtage, des composantes de fréquence du signal numérique résultant en dessous d'une fréquence de coupure f entre 2 Hz et 4 kHz sont atténuées.

**20.** Procédé selon la revendication 19, dans lequel un niveau de bruit est mesuré et la fréquence de coupure (f) est déterminée en fonction du niveau de bruit mesuré (S).

**21.** Procédé selon la revendication 20, dans lequel la fréquence de coupure (f') est déterminée par une fonction non linéaire du niveau de bruit (S).

**22.** Procédé selon la revendication 14, dans lequel une activation et/ou un établissement de la dépendance de fréquence du filtre passe-bas est réalisé en fonction de l'amplification dans l'étape d'amplification de nivellement.

**23.** Programme informatique comprenant des moyens de code informatique pour réaliser un procédé selon l'une quelconque des revendications 14 à 22 quand ledit programme est exécuté sur un ordinateur.

**24.** Produit de programme informatique comprenant des moyens de code informatique stockés sur un support lisible par ordinateur pour réaliser un procédé selon l'une quelconque des revendications 14 à 22.

FIG.1

FIG.2

FIG.3

FIG.4

FIG.5

FIG.6

FIG.7

FIG.8

FIG.9

FIG.10

AVL input amplitude step

AVL gain

FIG.11

EP 1 680 781 B1

FIG.12

FIG.13

FIG.14